(19) Europäisches Patentamt
European Patent Office
Office européen des brevets

(11) EP 3 020 549 B1

(12) EUROPEAN PATENT SPECIFICATION

(45) Date of publication and mention of the grant of the patent:
**15.11.2017 Bulletin 2017/46**

(21) Application number: **14840902.2**

(22) Date of filing: **29.08.2014**

(51) Int Cl.:
***H01L 41/45*** *(2013.01)* ***H01L 41/193*** *(2006.01)*
***H01L 41/053*** *(2006.01)* ***H01L 41/083*** *(2006.01)*

(86) International application number:
**PCT/JP2014/072738**

(87) International publication number:
**WO 2015/030174 (05.03.2015 Gazette 2015/09)**

(54) **LAMINATE BODY**

LAMINATKÖRPER

CORPS STRATIFIÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.09.2013 JP 2013181698**

(43) Date of publication of application:
**18.05.2016 Bulletin 2016/20**

(73) Proprietor: **Mitsui Chemicals, Inc.**
**Tokyo 105-7117 (JP)**

(72) Inventors:
- **TANIMOTO, Kazuhiro**
**Nagoya-shi**
**Aichi 457-8522 (JP)**
- **YOSHIDA, Mitsunobu**
**Nagoya-shi**
**Aichi 457-8522 (JP)**
- **NISHIKAWA, Shigeo**
**Nagoya-shi**
**Aichi 457-8522 (JP)**

(74) Representative: **Hoffmann Eitle**
**Patent- und Rechtsanwälte PartmbB**
**Arabellastraße 30**
**81925 München (DE)**

(56) References cited:
**WO-A1-2010/104196**
**WO-A1-2013/054918**
**JP-A- H05 299 720**
**JP-A- 2005 203 590**
**JP-A- 2012 056 239**
**JP-A- 2013 131 319**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

Technical Field

The present invention relates to a layered body.

Background Art

Recently, a polymeric piezoelectric body using an optically active aliphatic polyester (for example, a polylactic acid-type polymer) has been reported.

For example, a polymeric piezoelectric body exhibiting a piezoelectric modulus of approximately 10 pC/N at normal temperature, which is attained by a stretching treatment of a molding of a polylactic acid, has been disclosed (for example, refer to Japanese Patent Application Laid-Open (JP-A) No. H5-152638).

It has been also reported that a high piezoelectricity of approximately 18 pC/N can be achieved by a special orientation method called a forging process for highly orientating a polylactic acid crystal (for example, refer to JP-A No. 2005-213376). Reference is likewise made to the prior art document JP 2012056239.

SUMMARY OF INVENTION

Technical Problem

A layer a part of which is in contact with a polymeric piezoelectric body may be provided on the polymeric piezoelectric body, for example, in order to protect the polymeric piezoelectric body or to bond the polymeric piezoelectric body to another component (polymer film, glass, electrode, or the like). A layer having an acid value may be used as such a layer.

However, by studies of the present inventors and the like, the following has been found. That is, in a layered body including a polymeric piezoelectric body containing an aliphatic polyester and a layer which is in contact with the polymeric piezoelectric body and has an acid value, although the layer having an acid value is only in contact with a surface of the polymeric piezoelectric body, stability of the whole polymeric piezoelectric body (particularly, moist heat resistance under a large load such as a 85°C 85% RH test) may become lower than the polymeric piezoelectric body itself by an acid component in the layer having an acid value. Specifically, it has been found that an ester bond of the aliphatic polyester is broken by this acid component, the aliphatic polyester is decomposed (that is, molecular weight is reduced), this decomposition is transmitted to the whole aliphatic polyester, and as a result, the mechanical strength or electric characteristics (piezoelectric constant or the like) of a polymeric piezoelectric body may be lowered. In other words, when a polymeric piezoelectric body is used, for example, as a sensor or an actuator, cracks are generated in the polymeric piezoelectric body under a moist and heat environment to deteriorate appearance, or operation failure of the sensor or the actuator occurs.

It has been also found that the reduction in stability (for example, the reduction in molecular weight) can be suppressed by including an extremely small amount of the acid component in the layer or including no acid component in the layer, but an adhesive force between a polymeric piezoelectric body and a layer having an acid value is reduced.

The invention has been achieved in view of the above, and aims at achieving the following object.

That is, an object of the invention is to provide a layered body which includes a polymeric piezoelectric body and a layer having an acid value, has excellent stability (particularly, moist heat resistance) of the polymeric piezoelectric body, and has an excellent adhesive force between the polymeric piezoelectric body and the layer having an acid value.

Solution to Problem

Specific means to solve a problem are as follows.

<1> A layered body including a polymeric piezoelectric body which contains an optically active aliphatic polyester (A) having a weight average molecular weight of from 50,000 to 1,000,000 and has crystallinity obtained by a DSC method, of from 20% to 80%, and a layer (X) which is in contact with the polymeric piezoelectric body and has an acid value of 10 mgKOH/g or less.

<2> The layered body according to <1>, in which the layer (X) is an easy adhesive layer, an adhesive layer, a pressure sensitive adhesive layer, a hard coat layer, an antistatic layer, an antiblock layer, or a refractive index adjusting layer.

<3> The layered body according to <1> or <2>, in which the layer (X) is a pressure sensitive adhesive layer or an adhesive layer.

<4> The layered body according to any one of <1> to <3>, in which the acid value of the layer (X) is 0.01 mgKOH/g or more.

<5> The layered body according to any one of <1> to <4>, in which a total amount of nitrogen in the layer (X) is from 0.05% by mass to 10% by mass.

<6> The layered body according to any one of <1> to <5>, in which the polymeric piezoelectric body includes from 0.01 parts by mass to 10 parts by mass of a stabilizer (B), which has at least one functional group selected from the group consisting of a carbodiimide group, an epoxy group, and an isocyanate group, and has a weight average molecular weight of from 200 to 60,000, with respect to 100 parts by mass of the aliphatic polyester (A).

<7> The layered body according to <6>, in which the stabilizer (B) includes a stabilizer (B1), which has at least one functional group selected from the group consisting of a carbodiimide group, an epoxy group, and an isocyanate group, and has a weight average molecular weight of from 200 to 900, and in which the stabilizer (B) includes a stabilizer (B2) which has, in one molecule, two or more functional groups of one or more kinds selected from the group consisting of a carbodiimide group, an epoxy group, and an isocyanate group, and has a weight average molecular weight of from 1,000 to 60,000.

<8> The layered body according to any one of <1> to <7>, in which the polymeric piezoelectric body has an internal haze with respect to visible light, of 50% or less, and a piezoelectric constant $d_{14}$ measured at 25°C by a stress-charge method, of 1 pC/N or more.

<9> The layered body according to any one of <1> to <8>, in which the polymeric piezoelectric body has an internal haze with respect to visible light, of 13% or less, and includes from 0.01 parts by mass to 2.8 parts by mass of the stabilizer (B), which has at least one functional group selected from the group consisting of a carbodiimide group, an epoxy group, and an isocyanate group, and has a weight average molecular weight of from 200 to 60,000, with respect to 100 parts by mass of the aliphatic polyester (A).

<10> The layered body according to any one of <1> to <9>, in which the polymeric piezoelectric body has a product of the crystallinity and a standardized molecular orientation MORc measured by a microwave transmission-type molecular orientation meter based on a reference thickness of 50 μm, of from 25 to 700.

<11> The layered body according to any one of <1> to <10>, in which the aliphatic polyester (A) is a polylactic acid polymer having a main chain containing a repeating unit represented by the following Formula (1).

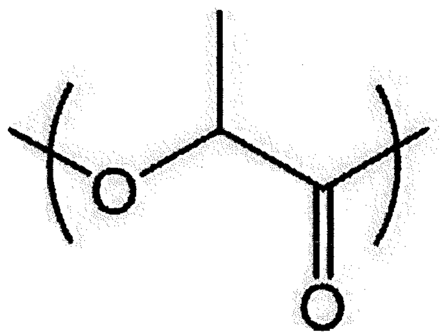

(1)

<12> The layered body according to any one of <1> to <11>, in which the aliphatic polyester (A) has an optical purity of 95.00%ee or more.

<13> The layered body according to any one of <1> to <12>, in which a content of the aliphatic polyester (A) in the polymeric piezoelectric body is 80% by mass or more.

Here, a "film" (for example, a "polymer film") is a concept including a sheet (for example, a polymer sheet).

Here, a numerical range represented by "from A to B" means a range including numerical values A and B as a lower limit value and an upper limit value, respectively. Advantageous Effects of Invention

According to the invention, a layered body which includes a polymeric piezoelectric body and a layer having an acid value, has excellent stability (particularly, moist heat resistance) of the polymeric piezoelectric body, and has an excellent adhesive force between the polymeric piezoelectric body and the layer having an acid value, is provided.

BRIEF DESCRIPTION OF DRAWINGS

Fig. 1 is a schematic side view schematically illustrating a cross section (cross section cut by a plane parallel to a longitudinal direction and a thickness direction) of a three-layer layered body used for measuring peeling strength (adhesive force) between a piezoelectric body and a pressure sensitive adhesive layer in Example 1.

DESCRIPTION OF EMBODIMENTS

A layered body of the invention includes a polymeric piezoelectric body (hereinafter, also simply referred to as "piezoelectric body") which contains an optically active aliphatic polyester (A) having a weight average molecular weight of from 50,000 to 1,000,000 and has crystallinity obtained by a DSC method, of from 20% to 80%, and a layer (X) which is in contact with the polymeric piezoelectric body and has an acid value of 10 mgKOH/g or less.

By studies of the inventors and the like, the following has been found. That is, in a layered body including a piezoelectric body containing an aliphatic polyester and a layer which is in contact with the piezoelectric body and has an acid value, although the layer having an acid value is only in contact with a surface of the polymeric piezoelectric body, the whole aliphatic polyester is decomposed by an acid component in the layer having an acid value, the molecular weight thereof is reduced, and as a result, stability of the polymeric piezoelectric body (particularly, moist heat resistance under a large load such as a 85°C 85% RH test) may become lower than the polymeric piezoelectric body itself.

It has been also found that the reduction in stability (for example, the reduction in molecular weight) can be suppressed by including an extremely small amount of the acid component in the layer or including no acid component in the layer, but an adhesive force between the piezoelectric body and the layer having an acid value is reduced.

The inventors and the like have found that the adhesive force between the piezoelectric body and the layer having an acid value can be enhanced while stability (particularly, moist heat resistance) of the piezoelectric body is maintained, by making the acid value of the layer having an acid value 10 mgKOH/g or less, and have completed the invention.

A reason why the adhesive force between the layer (X) and the piezoelectric body is enhanced in the invention is estimated as follows. That is, a part of the aliphatic polyester (A) is decomposed by an acid component in the layer (X), and a polar group is generated. As a result, a polar group of the layer (X) interacts with the polar group of the piezoelectric body in a contact surface between the layer (X) and the piezoelectric body.

In the invention, the "layer (X) having an acid value of 10 mgKOH/g or less" means the layer (X) having an acid value of more than 0 mgKOH/g but 10 mgKOH/g or less.

When the layer (X) has an acid value of 0 mgKOH/g, the adhesive force between the piezoelectric body and the layer (X) is reduced.

When the layer (X) has an acid value of more than 10 mgKOH/g, stability of the piezoelectric body is reduced. Specifically, the molecular weight of the aliphatic polyester in the piezoelectric body is reduced, and piezoelectricity (piezoelectric constant) is reduced. Furthermore, the mechanical strength of the piezoelectric body tends to be impaired by this reduction in the molecular weight.

In the layered body of the invention, the acid value of the layer (X) is preferably 0.01 mgKOH/g or more from a viewpoint of further improving the adhesive force between the piezoelectric body and the layer (X).

That is, the acid value of the layer (X) is preferably from 0.01 mgKOH/g to 10 mgKOH/g. The acid value of the layer (X) is more preferably from 0.05 mgKOH/g to 5 mgKOH/g, and still more preferably from 0.1 mgKOH/g to 1 mgKOH/g.

In the layered body of the invention, the acid value of the layer (X) means the amount of KOH (mg) required for neutralizing a free acid in 1 g of the layer (X). This amount of KOH (mg) is measured by titrating the layer (X) dissolved or swelled in a solvent with a 0.005M KOH (potassium hydroxide) ethanol solution using phenolphthalein as an indicator.

In the layered body of the invention, the total amount of nitrogen in the layer (X) is preferably from 0.05% by mass to 10% by mass, more preferably from 0.1% by mass to 8% by mass, and still more preferably from 0.2% by mass to 5% by mass. By making the total amount of nitrogen in the layer (X) 0.05% by mass or more, it is possible to further enhance the adhesion between the layer (X) and the piezoelectric body while high piezoelectricity is maintained. By making the total amount of nitrogen in the layer (X) 1.0% by mass or more, moist heat resistance is improved. By making the total amount of nitrogen in the layer (X) 10% by mass or less, an effect that the yellow color of the layer (X) is reduced can be obtained. The total amount of nitrogen in the layer (X) may be measured by the method described in Examples below.

A reason why the adhesion between the layer (X) and the piezoelectric body is enhanced is estimated as follows. That is, a part containing an oxygen atom in the aliphatic polyester (A) is decomposed by an acid component in the layer (X), and a polar group containing an oxygen atom is generated. A polar group containing a nitrogen atom in the layer (X) interacts with the polar group containing an oxygen atom in the piezoelectric body in a contact surface between the layer (X) and the piezoelectric body. The adhesion between the layer (X) and the piezoelectric body is thereby further enhanced.

A reason why the moist heat resistance is improved is not clear, but is estimated as follows. That is, an acid component in the layer (X) is trapped by a nitrogen component in the layer (X), movement of the acid component to the piezoelectric body is suppressed, and moist heat resistance is thereby improved.

The layered body of the invention may include another component on the layer (X).

Here, "on the layer (X)" refers to a side opposite to the side on which the polymeric piezoelectric body is present as viewed from the layer (X).

Examples of another component include a polymeric film, glass, and an electrode.

As a material (polymer) of the polymeric film, a polymer having high heat resistance is suitable. Examples thereof include polyethylene terephthalate (PET), polycarbonate (PC), polyvinyl alcohol (PVA), a cycloolefin polymer (COP), polymethyl methacrylate (PMMA), triacetyl cellulose (TAC), and polyimide (PI).

Examples of a material of the electrode include an opaque material such as Al, Cu, Ag, Ag paste, or carbon black, and a transparent material such as ITO (crystalline ITO and amorphous ITO), ZnO, IGZO, IZO, a conductive polymer (polythiophene, PEDOT), an Ag nanowire, a carbon nanotube, or graphene.

The electrode may be an electrode layer covering the entire layer (X) or an electrode pattern formed so as to cover a part of the layer (X). The electrode may be formed on a substrate such as a polymeric film or glass.

When the layered body includes an electrode, the layer (X) may be in contact with the electrode, in contact with the substrate, or in contact with both the electrode and the substrate. For example, when an electrode is an electrode pattern formed so as to cover a part on the substrate, the layer (X) may be in contact with both the electrode and the substrate.

An electrode(s) may be provided only on one principal plane of the polymeric piezoelectric body, or may be provided on both principal planes. An electrode may be provided on one principal plane of the polymeric piezoelectric body through the layer (X), and an electrode may be provided directly (that is, in contact with the polymeric piezoelectric body) on the other principal plane of the polymeric piezoelectric body.

Examples of the layered structure of the layered body of the invention include the following, for example, when the polymeric piezoelectric body is referred to as A, the layer (X) is referred to as X, the substrate (polymeric film or glass) is referred to as B, and the electrode is referred to as C.

That is, examples of the layered structure include A/X, X/A/X, A/X/B, X/A/X/B, B/X/A/X/B, A/X/C, X/A/X/C, C/X/A/X/C, C/A/X, C/A/X/C, X/C/A/X/C, A/XB/C, A/X/CB, X/A/XB/C, X/A/X/C/B, C/A/X/B, C/A/X/B/C, C/A/X/CB, X/C/A/X/B, X/C/A/X/B/C, X/C/A/X/C/B, B/X/C/A/X/B/C, and B/X/C/A/X/C/B. Examples thereof also include a layered structure having these layered structures as a partial structure.

[Layer (X)]

The layer (X) according to the invention is a layer in contact with the polymeric piezoelectric body.

In the layered body of the invention, at least a part of the layer (X) is only required to be in contact with the polymeric piezoelectric body.

In the layered body of the invention, the layer(s) (X) may be provided only on one principal plane of the polymeric piezoelectric body, or may be provided on both principal planes of the polymeric piezoelectric body.

A multilayer film in which a plurality of functional layers is layered may be provided on the polymeric piezoelectric body according to the invention. In this case, the layer (X) means a layer disposed such that at least a part thereof is in contact with the piezoelectric body.

<Kind (Function) of Layer (X)>

Examples of the layer (X) according to the invention include various functional layers.

Examples of the functional layer include an easy adhesive layer, a hard coat layer, a refractive index adjusting layer, an antireflection layer, an antiglare layer, an easily slippable layer, an antiblock layer, a protective layer, an adhesive layer, a pressure sensitive adhesive layer, an antistatic layer, a heat dissipation layer, an ultraviolet absorbing layer, an anti-Newton ring layer, a light scattering layer, a polarizing layer, and a gas barrier layer. The functional layer may have two or more of these functions.

The layer (X) is preferably an easy adhesive layer, an adhesive layer, a pressure sensitive adhesive layer, a hard coat layer, an antistatic layer, an antiblock layer, or a refractive index adjusting layer, and is more preferably an adhesive layer or a pressure sensitive adhesive layer.

When the layers (X) are provided on both principal planes of the polymeric piezoelectric body, the two layers (X) may be the same functional layer or different functional layers.

By the layered body including the layer (X), a defect such as a die line or a dent on the surface of the piezoelectric body is filled, and there is an effect that appearance is improved. In this case, the smaller the difference in a refractive index between the piezoelectric body and the layer (X) is, the less the reflection on the interface between the piezoelectric body and the layer (X) is, and the better the appearance is.

<Material of Layer (X)>

A material of the layer (X) is not particularly limited, and the layer (X) preferably includes a resin.

Examples of the resin include an acrylic resin, a methacrylic resin, a urethane resin, a cellulose resin, a vinyl

acetate resin, an ethylene-vinyl acetate resin, an epoxy resin, a nylon-epoxy resin, a vinyl chloride resin, a chloroprene rubber resin, a cyanoacrylate resin, a silicone resin, a modified silicone resin, an aqueous polymer-isocyanate resin, a styrenebutadiene rubber resin, a nitrile rubber resin, an acetal resin, a phenol resin, a polyamide resin, a polyimide resin, a melamine resin, a urea resin, a bromine resin, a starch resin, a polyester resin, and a polyolefin resin.

Particularly when the layer (X) is an adhesive layer or a pressure sensitive adhesive layer, the resin is preferably an acrylic resin, a methacrylic resin, or an epoxy resin, and is particularly preferably an acrylic resin or a methacrylic resin.

The adhesive layer can be formed, for example, using an adhesion coating liquid such as a solvent-based, non-solvent-based, or water-based adhesion coating liquid, or a hotmelt adhesive.

As the pressure sensitive adhesive layer, for example, a pressure sensitive adhesive layer of a double-sided tape both surfaces of which are laminated with a separator (OCA; Optical Clear Adhensive) can be used. The pressure sensitive adhesive layer can be also formed using a pressure sensitive adhesion coating liquid such as a solvent-based, non-solvent-based, or water-based pressure sensitive adhesion coating liquid, a UV curable OCR (Optical Clear Resin), or the like.

Examples of the OCA include optical transparent pressure sensitive adhesive sheet LUCIACS series manufactured by Nitto Denko Corporation, highly transparent double-sided tape 5400A series manufactured by Sekisui Chemical Co., Ltd., optical pressure sensitive adhesive sheet Opteria series manufactured by Lintec Corporation, highly transparent pressure sensitive adhesive transfer tape series manufactured by Sumitomo 3M Company, SANCUARY series manufactured by Sun A. Kaken Co., Ltd., highly transparent base less double sided pressure sensitive adhesive film manufactured by TOYOHOZAI Co., Ltd., optical core-free double-sided tape RA series manufactured by Sumiron Co., Ltd., optical pressure sensitive adhesive non carrier series manufactured by Tomoegawa Co. Ltd., mastack series manufactured by Fujimori Kogyo Co., Ltd., and PANACLEAN series manufactured by PANAC Corporation.

Examples of the pressure sensitive adhesion coating liquid include SK-dyne series manufactured by Soken Chemical & Engineering Co., Ltd., FINETAC series and VONCOAT series manufactured by DIC Corporation, LKG series manufactured by Fujikura Kasei Co., Ltd., and CORPONIEL series manufactured by The Nippon Synthetic Chemical Industry Co., Ltd.

When the layer (X) includes a resin, the layer (X) may include a component (a solvent, an additive, or the like) other than the resin in order to exhibit functions thereof.

However, an additive may be colored under a specific environment (particularly at a high temperature and a high humidity) or may increase a haze. Therefore, preferably, the layer (X) does not include such a material.

When the layer (X) includes a resin, the content of the resin in the layer (X) is preferably 60% by mass or more.

The resin is preferably a curable resin (a thermosetting resin or an active energy ray curable resin).

As the curable resin, a publicly known curable resin, for example, resins described in paragraphs 0040 to 0044, 0076 to 0078, and 0100 to 0107 of WO 2010/114056 A can be selected and used, if appropriate.

The layer (X) preferably also includes a carbonyl group (-C(=O)-) from a viewpoint of further improving the adhesive force between the piezoelectric body and the layer (X).

The layer (X) preferably also includes a resin having a three-dimensional crosslinked structure from a similar viewpoint.

An Example of a method of forming the layer (X) including a carbonyl group and a resin (polymer) is a method of polymerizing a composition containing a compound having a carbonyl group and a functional compound having a reactive group. In this case, the compound having a carbonyl group may be the same as or different from the functional compound.

When the compound having a carbonyl group is the same as the functional compound, the reactive group itself of the functional compound may include a carbonyl group, or a structure other than the reactive group of the functional compound may include a carbonyl group. When the compound having a carbonyl group is not the same as the functional compound, the compound having a carbonyl group has one or more reactive groups which can react with the functional compound.

The polymerization reaction may be performed between one kinds of reactive groups or between two or more different kinds of reactive groups. When the polymerization reaction is performed between two or more different kinds of reactive groups, one compound may have two or more different kinds of reactive groups, or a functional compound having two or more reactive groups of the same kind may be mixed with a functional compound having two or more other reactive groups which can react with the reactive groups.

Examples of the reactive group which performs a reaction between the reactive groups of the same kind (hereinafter, also simply referred to as a "homologous reactive group") include an acrylic group, a methacrylic group, a vinyl group, an allyl group, an isocyanate group, and an epoxy group. The reactive group of each of an acrylic group, a methacrylic group, and an isocyanate group has a carbonyl group. When a vinyl group, an allyl group, or an epoxy group is used, it is possible to use a compound having a carbonyl group in a structure other than the reactive group.

From a viewpoint of imparting a three-dimensional crosslinked structure to the polymer, when a compound having two or more functional groups of these homologous reactive groups is present even in a part of a composition,

the homologous reactive groups can form the three-dimensional crosslinked structure.

Examples of the reactive group which performs a reaction between the reactive groups of two or more kinds (hereinafter, also simply referred to as a "heterologous reactive group") include combinations of an epoxy group and a carboxyl group, an epoxy group and an amino group, an epoxy group and a hydroxyl group, an epoxy group and an acid anhydride group, an epoxy group and a hydrazide group, an epoxy group and a thiol group, an epoxy group and an imidazole group, an epoxy group and an isocyanate group, an isocyanate group and a carboxyl group, an isocyanate group and an amino group, an isocyanate group and a hydroxyl group, a carbodiimide group and an amino group, a carbodiimide group and a carboxyl group, an oxazolino group and a carboxyl group, and a hydrazide group and a carboxyl group.

From a viewpoint of imparting a three-dimensional crosslinked structure to the polymer, when a compound having three or more functional groups of one or both of these heterologous reactive groups is present even in a part of a composition, the heterologous reactive groups can form the three-dimensional crosslinked structure.

Among these groups, the reactive group of each of a carboxyl group, an acid anhydride group, a hydrazide group, and an isocyanate group has a carbonyl group. When a reactive group other than these groups is used, it is possible to use a compound having a carbonyl group in a structure other than the reactive group.

Examples of a functional compound having an epoxy group and a carbonyl group in one molecule include epoxy acrylate.

Examples of a functional compound having a hydroxyl group and a carbonyl group in one molecule include polyester polyol, polyurethane polyol, acrylic polyol, polycarbonate polyol, and partial carboxymethyl cellulose.

Examples of a functional compound having an amino group and a carbonyl group in one molecule include terminal amine polyamide, terminal amine polyimide, and terminal amine polyurethane.

As the polymer, a polymer of a compound having a (meth)acrylic group is more preferable among the above-described compounds.

The "(meth)acrylic" means including acrylic and methacrylic.

<Forming Method>

As a method of forming the layer (X) on the piezoelectric body, it is possible to use a publicly known method which has been conventionally and generally used, if appropriate. Examples thereof include a wet coating method. For example, the layer (X) is formed by coating the layer (X) with a coat liquid in which a material for forming the layer (X) (a polymerizable compound or a polymer of a polymerizable compound) is dispersed or dissolved and drying or the like, if necessary. Polymerization of a polymerizable compound may be performed before or after coating.

Furthermore, if necessary, the layer (X) may be cured by irradiating the material (polymerizable compound) with heat or an active energy ray (an ultraviolet ray, an electron beam, radiation, or the like) during the polymerization. By reducing the equivalent amount of the reactive group in the material (polymerizable compound) for forming the layer (X) (that is, by increasing the number of reactive groups contained in unit molecular weight of the polymerizable compound), the crosslinking density is increased, and it is possible to further improve the adhesion to the piezoelectric body.

Among the above polymers, an active energy ray curable resin cured by irradiation with an active energy ray (an ultraviolet ray, an electron beam, radiation, or the like) is preferable. By containing an active energy ray curable resin, a manufacturing efficiency is improved, and it is possible to further improve the adhesion to the piezoelectric body.

Examples of the method of forming the layer (X) on the piezoelectric body also include a method of sticking (transferring) the layer (X) provided on a temporary support such as a polymer film to the piezoelectric body (hereinafter, also referred to as a "sticking method"). After sticking, the temporary support may be left as it is or may be peeled and removed, if necessary. In the above sticking method, examples of the method of forming the layer (X) on a temporary support include the above wet coating method.

The sticking method is particularly suitable when the layer (X) is a pressure sensitive adhesive layer.

The sticking method is advantageous in that heat history (heat history due to performing a drying step or the like) to the piezoelectric body can be reduced. Therefore, the sticking method is particularly suitable when the piezoelectric body has low heat resistance.

Examples of the sticking method include a method of sticking a pressure sensitive adhesive layer (corresponding to the above "layer (X)") provided on a separator (corresponding to the above "temporary support") to the piezoelectric body.

<Three-dimensional Crosslinked Structure>

The layer (X) preferably also includes a polymer having a carbonyl group and a three-dimensional crosslinked structure. It is possible to further improve the adhesion to the piezoelectric body and solvent resistance of the layer (X) by having the three-dimensional crosslinked structure.

Examples of a method of manufacturing a polymer having a three-dimensional crosslinked structure include a method of polymerizing a composition containing a functional compound having two or more reactive groups. Examples thereof also include a method using isocyanate, a polyol, an organic peroxide, or the like as a crosslinking agent. These methods may be used in combination thereof.
Examples of a functional compound having two or more functional groups include a (meth)acrylic compound having two or more (meth)acrylic groups in one molecule.
Examples of a functional compound having three or more functional groups include an epoxy compound having three or more epoxy groups in one molecule and an isocyanate compound having three or more isocyanate groups in one molecule.
Here, examples of a method of confirming whether a material included in the layer (X) is a polymer having a three-dimensional crosslinked structure include a method of measuring a gel fraction.
Specifically, it is possible to obtain the gel fraction from an insoluble content after the layer (X) is immersed in a solvent for 24 hours. Particularly, even when the solvent is a hydrophilic solvent such as water or a lipophilic solvent such as toluene, it is possible to estimate that a polymer having a gel fraction of a constant value or more has a three-dimensional crosslinked structure.
In the wet coating method, after a raw material of the piezoelectric body before stretching is coated with a coat liquid, the piezoelectric body may be stretched and then cured. Alternatively, after the raw material of the piezoelectric body is stretched, the piezoelectric body may be coated with a coat liquid and may be cured.
It is possible to add various organic substances and inorganic substances such as a refractive index adjusting agent, an ultraviolet absorber, a leveling agent, an antistatic agent, and an antiblocking agent to the layer (X) depending on the purpose.

<Surface Treatment>

It is also possible to treat a surface of the piezoelectric body by a corona treatment, an Itro treatment, an ozone treatment, a plasma treatment, or the like, from viewpoints of further improving the adhesion between the surface of the piezoelectric body and the layer (X), and coatability of the layer (X) to the surface of the piezoelectric body.

<Thickness>

The thickness of the layer (X) (average thickness; hereinafter, also referred to as "thickness d") is not particularly limited, and is preferably in a range of from 0.01 μm to 200 μm, more preferably in a range of from 0.1 μm to 100 μm, still more preferably in a range of from 0.2 μm to 80 μm, and particularly preferably in a range of from 1 μm to 70 μm.
The adhesion between the surface of the piezoelectric body and the layer (X) is further improved by the thickness d having the above lower limit value or more.
When an electrode is further provided on the layer (X), a larger charge is generated in the electrode by the thickness having the above upper limit value or less.
However, the layers (X) may be provided on both surfaces of the piezoelectric body. In this case, the thickness d is a total of the thicknesses on both the surfaces.
The thickness (thickness d) of the layer (X) is determined according to the following formula using a digital length measuring machine DIGIMICRO STAND MS-11C manufactured by Nikon Corporation.

$$\text{Formula } d = dt - dp$$

dt: average thickness of the layered body at ten places
dp: average thickness of the piezoelectric body at ten places before the layer (X) is formed or after the layer (X) is removed.

<Relative Dielectric Constant>

The relative dielectric constant of the layer (X) is preferably 1.5 or more, more preferably from 2.0 to 20,000, and still more preferably from 2.5 to 10,000.
When an electrode is further provided on the layer (X) in the layered body, a larger charge is generated in the electrode by the relative dielectric constant within the above range.
The relative dielectric constant of the layer (X) is measured by the following method.
The layer (X) is formed on one surface of the piezoelectric body, and then Al of about 50 nm is deposited on

both surfaces of the layered body using a Showa Shinku SIP-600. A film of 50 mm×50 mm is cut out from the layered body. This specimen is connected to a LCR METER 4284A manufactured by Hewlett-Packard Development Company, L.P., and an electrostatic capacity C is measured. The relative dielectric constant εc of the layer (X) is calculated according to the following formula.

$$\varepsilon c = (C \times dc \times 2.7)/(\varepsilon_0 \times 2.7 \times S - C \times dp)$$

dc: thickness of layer (X), $\varepsilon_0$: vacuum dielectric constant, S: area of specimen, dp: thickness of piezoelectric body

<Internal Haze of Layer (X)>

The internal haze of the layer (X) is preferably 10% or less, more preferably from 0.0% to 5%, and still more preferably from 0.01% to 2%.

By the internal haze within the above range, the layer (X) exhibits excellent transparency and can be used effectively, for example, as a touch panel.

An internal haze Hc of the layer (X) is calculated according to the following formula.

$$Hc = H - Hp$$

H: internal haze of the layered body
Hp: internal haze of the piezoelectric body before the layer (X) is formed or after the layer (X) is removed

Here, the internal haze of the piezoelectric body is a value obtained when a haze of a polymeric piezoelectric body having a thickness of 0.03 mm to 0.05 mm is measured in accordance with JIS-K7105 using a haze measuring machine [TC-HIII DPK manufactured by Tokyo Denshoku Co., Ltd.,] at 25°C. Details of the measurement method will be described in Examples.

The internal haze of the layered body is also measured in accordance with the above method of measuring the internal haze of the piezoelectric body.

[Polymeric Piezoelectric Body]

The polymeric piezoelectric body according to the invention contains the optically active aliphatic polyester (A) having a weight average molecular weight of from 50,000 to 1,000,000 and has crystallinity obtained by a DSC method, of from 20% to 80%.

<Optically Active Aliphatic Polyester (A)>

The polymeric piezoelectric body according to the invention contains the optically active aliphatic polyester (A) (hereinafter, also simply referred to as "aliphatic polyester (A)") having a weight average molecular weight of from 50,000 to 1,000,000.

Here, an optically active aliphatic polyester means an aliphatic polyester having optical activity derived from a molecular structure, such as an aliphatic polyester having a helical structure as the molecular structure thereof and having molecular optical activity.

Examples of the optically active aliphatic polyester (hereinafter also referred to as an "optically active polymer") include a polylactic acid polymer and a poly(β-hydroxybutyrate). The optically active aliphatic polyester is preferably a helical chiral polymer piezoelectricity of which is easily increased.

The optical purity of the aliphatic polyester (A) (optically active polymer) is preferably 95.00%ee or more, more preferably 96.00%ee or more, still more preferably 99.00%ee or more, and further still more preferably 99.99%ee or more, from a viewpoint of improving piezoelectricity of a polymeric piezoelectric body. The optical purity is desirably 100.00%ee. It is considered that, by the optical purity of the aliphatic polyester (A) within the above range, a packing property of a polymer crystal exhibiting piezoelectricity is enhanced, and as a result, the piezoelectricity is increased.

In the present embodiment, the optical purity of the aliphatic polyester (A) (optically active polymer) is a value calculated according to the following formula.

$$\text{Optical purity (\%ee)} = 100 \times |\text{L-form amount - D-form amount}|/(\text{L-form amount + D-form amount})$$

That is, a value obtained by dividing a "difference (absolute value) between L-form amount [% by mass] of the optically active polymer and D-form amount [% by mass] of the optically active polymer" by "the total of L-form amount [% by mass] of the optically active polymer and D-form amount [% by mass] of the optically active polymer" and then multiplying the value thus obtained by "100" is defined as optical purity.

For the L-form amount [% by mass] of the optically active polymer and the D-form amount [% by mass] of the optically active polymer, values obtained by a method using high performance liquid chromatography (HPLC) are used. Details of a specific measurement will be described below.

Among the above aliphatic polyesters (A) (optically active polymers), a compound having a main chain containing a repeating unit represented by Formula (1) below is preferable from viewpoints of improving the optical purity and piezoelectricity.

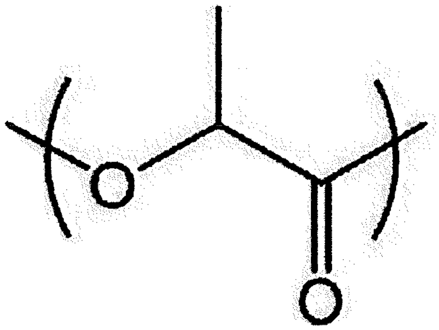

(1)

Examples of the compound having a repeating unit represented by Formula (1) above as a main chain include a polylactic acid-type polymer.

Among the polylactic acid-type polymers, polylactic acid is preferable, and a homopolymer of L-lactic acid (PLLA) or a homopolymer of D-lactic acid (PDLA) is most preferable.

The polylactic acid-type polymer in the present embodiment means a "polylactic acid (a polymer compound constituted only by repeating units derived from monomer(s) selected from L-lactic acid and D-lactic acid)", a "copolymer of one of L-lactic acid and D-lactic acid and a compound copolymerizable with the L-lactic acid or the D-lactic acid", or a mixture of the two.

The "polylactic acid" is a polymer obtained by polymerization of lactic acid through ester bonds into a long chain. It is known that polylactic acid can be manufactured by a lactide method via a lactide, a direct polymerization method in which lactic acid is heated in a solvent under a reduced pressure for polymerization while water is removed, or the like. Examples of the "polylactic acid" include a homopolymer of L-lactic acid, a homopolymer of D-lactic acid, a block copolymer including a polymer of at least one of L-lactic acid and D-lactic acid, and a graft copolymer including a polymer of at least one of L-lactic acid and D-lactic acid.

Examples of the "compound copolymerizable with L-lactic acid or D-lactic acid" include a hydroxycarboxylic acid such as glycolic acid, dimethyl glycolic acid, 3-hydroxybutyric acid, 4-hydroxybutyric acid, 2-hydroxypropanoic acid, 3-hydroxypropanoic acid, 2-hydroxyvaleric acid, 3-hydroxyvaleric acid, 4-hydroxyvaleric acid, 5-hydroxyvaleric acid, 2-hydroxycaproic acid, 3-hydroxycaproic acid, 4-hydroxycaproic acid, 5-hydroxycaproic acid, 6-hydroxycaproic acid, 6-hydroxymethylcaproic acid, or mandelic acid; a cyclic ester such as glycolide, β-methyl-δ-valerolactone, γ-valerolactone, or ε-caprolactone; a polycarboxylic acid such as oxalic acid, malonic acid, succinic acid, glutaric acid, adipic acid, pimelic acid, azelaic acid, sebacic acid, undecanedioic acid, dodecanedioic acid, or terephthalic acid, and an anhydride thereof; a polyhydric alcohol such as ethyleneglycol, diethyleneglycol, triethyleneglycol, 1,2-propanediol, 1,3-propanediol, 1,3-butanediol, 1,4-butanediol, 2,3-butanediol, 1,5-pentanediol, 1,6-hexanediol, 1,9-nonanediol, 3-methyl-1,5-pentanediol, neopentylglycol, tetramethyleneglycol, or 1,4-hexanedimethanol; a polysaccharide such as cellulose; and an aminocarboxylic acid such as α-amino acid.

Examples of the "copolymer of one of L-lactic acid and D-lactic acid and a compound copolymerizable with the L-lactic acid or the D-lactic acid" include a block copolymer or a graft copolymer having a polylactic acid sequence which can form a helical crystal.

The concentration of a structure derived from a copolymer component in the above copolymer is preferably 20 mol% or less.

For example, when the aliphatic polyester (A) is a polylactic acid-type polymer, with respect to the total number of moles of a structure derived from lactic acid and a structure derived from a compound copolymerizable with lactic acid (copolymer component) in the polymer, the copolymer component is preferably 20 mol% or less.
The polylactic acid-type polymer can be manufactured, for example, by a method of obtaining the polymer by direct dehydration condensation of lactic acid, described in JP-A No. S59-096123 and JP-A No. H7-033861, or a method of obtaining the polymer by a ring-opening polymerization of lactide which is a cyclic dimer of lactic acid, described in U.S. Patents Nos. 2,668,182 and 4,057,357, or the like.
In order to make the optical purity of the aliphatic polyester (A) obtained by any of the above manufacturing methods 95.00%ee or more, for example, when a polylactic acid is manufactured by a lactide method, it is preferable to polymerize lactide the optical purity of which has been enhanced to 95.00%ee or more by a crystallization operation.
The weight average molecular weight (Mw) of the aliphatic polyester (A) is from 50,000 to 1,000,000.
When the weight average molecular weight of the aliphatic polyester (A) is less than 50,000, the mechanical strength of the polymeric piezoelectric body becomes insufficient. The weight average molecular weight of the aliphatic polyester (A) is preferably 100,000 or more, and more preferably 150,000 or more.
When the upper limit of the weight average molecular weight of the aliphatic polyester (A) exceeds 1,000,000, molding the polymeric piezoelectric body (for example, molding the polymeric piezoelectric body into a film shape or the like by extrusion molding or the like) becomes difficult. The weight average molecular weight of the aliphatic polyester (A) is preferably 800,000 or less, and more preferably 300,000 or less.
The molecular weight distribution (Mw/Mn) of the aliphatic polyester (A) is preferably from 1.1 to 5, and more preferably from 1.2 to 4, from a viewpoint of the strength of the polymeric piezoelectric body. The molecular weight distribution is still more preferably from 1.4 to 3.
The weight average molecular weight Mw and the molecular weight distribution (Mw/Mn) of the aliphatic polyester (A) are measured using a gel permeation chromatograph (GPC) by the following GPC measuring method.

-GPC measuring apparatus-

GPC-100 manufactured by Waters Corp.

-Column-

Shodex LF-804 manufactured by Showa Denko K.K.

-Preparation of sample-

The aliphatic polyester (A) is dissolved in a solvent (for example, chloroform) at 40°C to prepare a sample solution having a concentration of 1 mg/mL.

-Measurement condition-

0.1 mL of the sample solution is introduced into a column at a temperature of 40°C and a flow rate of 1 mL/min by using chloroform as a solvent.
The sample concentration in the sample solution separated by the column is measured by a differential refractometer. A universal calibration curve is created based on a polystyrene standard sample. The weight average molecular weight (Mw) and the molecular weight distribution (Mw/Mn) of the aliphatic polyester (A) are calculated.
For the polylactic acid-type polymer, a commercially available polylactic acid may be used, and examples thereof include PURASORB (PD, PL) manufactured by Purac Inc., LACEA (H-100, H-400) manufactured by Mitsui Chemicals, Inc., and Ingeo 4032D and 4043D manufactured by NatureWorks LLC.
When a polylactic acid-type polymer is used as the aliphatic polyester (A), it is preferable to manufacture the aliphatic polyester (A) by a lactide method or a direct polymerization method in order to make the weight average molecular weight (Mw) of the polylactic acid-type polymer 50,000 or more.
The content of the aliphatic polyester (A) contained in the polymeric piezoelectric body according to the invention is preferably 80% by mass or more.
Here, the change ratio in a molecular weight (a value obtained by dividing a weight average molecular weight Mw after a moist heat resistance test by a weight average molecular weight Mw before the moist heat resistance test) is preferably one or more, or nearly one even when the change ratio is smaller than one. This supports that hydrolyzability is suppressed and reliability is excellent. The change ratio in a molecular weight is preferably 0.5 or more, more preferably 0.6 or more, still more preferably 0.65 or more, and further still more preferably 0.7 or more.

<stabilizer (B)>

The polymeric piezoelectric body according to the invention preferably includes a stabilizer (B) which has at least one functional group selected from the group consisting of a carbodiimide group, an epoxy group, and an isocyanate group, and has a weight average molecular weight of from 200 to 60,000.

This makes it possible to further suppress a hydrolysis reaction of the aliphatic polyester (A) and to further improve the moist heat resistance of the polymeric piezoelectric body.

For the stabilizer (B), it is possible to refer to the description of paragraphs 0039 to 0055 of WO 2013/054918 A, if appropriate.

(Carbodiimide Compound)

Examples of a compound having a carbodiimide group (carbodiimide compound) which can be used as the stabilizer (B) include a monocarbodiimide compound, a polycarbodiimide compound, and a cyclic carbodiimide compound.

Examples of the monocarbodiimide compound include dicyclohexylcarbodiimide, dimethylcarbodiimide, diisobutylcarbodiimide, dioctylcarbodiimide, t-butylisopropylcarbodiimide, diphenylcarbodiimide, di-t-butylcarbodiimide, and di-β-naphthylcarbodiimide. Among these monocarbodiimide compounds, from a viewpoint of particularly easy industrial availability, dicyclohexylcarbodiimide, or bis-2,6-diisopropylphenylcarbodiimide is suitable.

As the polycarbodiimide compound, polycarbodiimide compounds manufactured by various methods can be used. Polycarbodiimide compounds manufactured by conventional methods of manufacturing a polycarbodiimide (for example, U.S. Patent No. 2941956, Japanese Patent Publication (JP-B) No. S47-33279, J. Org. Chem. 28, 2069-2075 (1963), Chemical Review 1981, Vol. 81, No. 4, p619-621) can be used. Specifically, a carbodiimide compound described in Japanese Patent No. 4084953 can be also used.

Examples of the polycarbodiimide compound include poly(4,4'-dicyclohexylmethanecarbodiimide), poly(tetramethylxylylenecarbodiimide), poly(N,N-dimethylphenylcarbodiimide), and poly(N,N'-di-2,6-diisopropylphenylcarbodiimide). The carbodiimide compound is not particularly limited as long as the carbodiimide compound has one or more carbodiimide groups in a molecule having such a function.

In a cyclic carbodiimide compound, the cyclic structure has one carbodiimide group (-N=C=N-), and a first nitrogen and a second nitrogen are bonded by a boding group. One cyclic structure has only one carbodiimide group. A cyclic carbodiimide compound can have one or more carbodiimide groups in a molecule thereof. When a cyclic carbodiimide compound has a plurality of cyclic structures such as a spiro ring in a molecule thereof, each cyclic structure bonded to a spiro atom has one carbodiimide group, and therefore the compound can have a plurality of carbodiimide groups in one molecule thereof. The number of atoms in the cyclic structure is preferably from 8 to 50, more preferably from 10 to 30, still more preferably from 10 to 20, and further still more preferably from 10 to 15.

Here, the number of atoms in the cyclic structure means the number of atoms constituting the cyclic structure directly. For example, when the cyclic structure is a 8-membered ring, the number of atoms is 8, and when the cyclic structure is a 50-membered ring, the number of atoms is 50. When the number of atoms in the cyclic structure is 8 or more, stability of the cyclic carbodiimide compound is improved, and storage and use thereof can be easy. The upper limit value of the number of ring members is not particularly limited from a viewpoint of reactivity. However, the number of atoms in the cyclic structure can be suitably 50 from a viewpoint of being able to prevent increase in cost due to difficulty in synthesis. The cyclic carbodiimide compound may have a plurality of cyclic structures.

The cyclic carbodiimide compound can be synthesized based on a method described in JP-A No. 2011-256337, or the like.

As the carbodiimide compound, a commercially available product may be used. Examples thereof include B2756 (trade name) manufactured by Tokyo Chemical Industry Co., Ltd., CARBODILITE LA-1 manufactured by Nisshinbo Chemical Inc., and Stabaxol P, Stabaxol P400, and Stabaxol I (all are trade names) manufactured by Rhein Chemie GmbH.

(Isocyanate Compound)

Examples of a compound having an isocyanate group (isocyanate compound) which can be used as the stabilizer (B) include hexyl isocyanate, cyclohexyl isocyanate, benzyl isocyanate, phenethyl isocyanate, butyl isocyanatoacetate, dodecyl isocyanate, octadecyl isocyanate, 3-(triethoxysilyl)propyl isocyanate, 2,4-tolylene diisocyanate, 2,6-tolylene diisocyanate, m-phenylene diisocyanate, p-phenylene diisocyanate, 4,4'-diphenylmethane diisocyanate, 2,4'-diphenylmethane diisocyanate, 2,2'-diphenylmethane diisocyanate, 3,3'-dimethyl-4,4'-biphenylene diisocyanate, 3,3'-dimethoxy-4,4'-biphenylene diisocyanate, 3,3'-dichloro-4,4'-biphenylene diisocyanate, 1,5-naphthalene diisocyanate, 1,5-tetrahydronaphthalene diisocyanate, tetramethylene diisocyanate, 1,6-hexamethylene diisocyanate, dodecamethylene diisocyanate, trimethylhexamethylene diisocyanate, 1,3-cyclohexylene diisocyanate, 1,4-cyclohexylene diisocyanate, xylylene diisocyanate, tetramethylxylylene diisocyanate, hydrogenated xylylene diisocyanate, lysine diisocyanate, isophorone diisocyanate, 4,4'-dicyclohexylmethane diisocyanate, or 3,3'-dimethyl-4,4'-dicyclohexylmethane diisocyanate, a diphenylmethane diisocyanate-type polyisocyanate, a 1,6-hexamethylene diisocyanate-type polyisocyanate, a xylylenediisocyanate-type polyisocyanate, and an isophoronediisocyanate-type polyisocyanate.

(Epoxy Compound)

Examples of a compound having an epoxy group (epoxy compound) which can be used as the stabilizer (B) include N-glycidyl phthalimide, ortho-phenylphenyl glycidyl ether, phenyl glycidyl ether, p-t-butylphenyl glycidyl ether, hydroquinone diglycidyl ether, resorcin diglycidyl ether, 1,6-hexanediol diglycidyl ether, diethyleneglycol diglycidyl ether, polyethylene glycol diglycidyl ether, trimethylolpropane triglycidyl ether, bisphenol A-diglycidyl ether, hydrogenated bisphenol A-diglycidyl ether, a phenol novolac-type epoxy resin, a cresol novolac-type epoxy resin, and epoxidized polybutadiene.

The weight average molecular weight of the stabilizer (B) is from 200 to 60,000 as described above, more preferably from 200 to 30,000, and still more preferably from 300 to 18,000.

When the molecular weight is within the above range, the stabilizer (B) moves more easily, and an effect of improving the moist heat resistance is exhibited more effectively.

The stabilizer (B) may be used singly, or in combination of two or more kinds thereof.

Examples of a preferable mode of the stabilizer (B) include a mode in which a stabilizer (B1) which has at least one functional group selected from the group consisting of a carbodiimide group, an epoxy group, and an isocyanate group, and has a number average molecular weight of from 200 to 900, and a stabilizer (B2) which has, in one molecule, two or more functional groups of one or more kinds selected from the group consisting of a carbodiimide group, an epoxy group, and an isocyanate group, and has a weight average molecular weight of from 1,000 to 60,000 are used in combination. Use of the stabilizer (B1) having a relatively low molecular weight and the multifunctional stabilizer (B2) having a relatively high molecular weight in combination improves the moist heat resistance particularly. The weight average molecular weight of the stabilizer (B1) having a number average molecular weight of from 200 to 900 is about from 200 to 900. The number average molecular weight and the weight average molecular weight of the stabilizer (B1) have almost the same values.

Here, specific examples of the stabilizer (B1) include dicyclohexylcarbodiimide, bis-2,6-diisopropylphenylcarbodiimide, hexyl isocyanate, octadecyl isocyanate, 3-(triethoxysilyl)propyl isocyanate, N-glycidyl phthalimide, ortho-phenylphenyl glycidyl ether, phenyl glycidyl ether, and p-t-butylphenyl glycidyl ether.

Specific examples of the stabilizer (B2) include poly(4,4'-dicyclohexylmethane carbodiimide), poly(tetramethylxylylene carbodiimide), poly(N,N-dimethylphenylcarbodiimide), poly(N,N'-di-2,6-diisopropylphenylcarbodiimide), poly(1,3,5-triisopropylphenylene-2,4-carbodiimide), a diphenylmethane diisocyanate-type polyisocyanate, a 1,6-hexamethylene diisocyanate-type polyisocyanate, a xylylene diisocyanate-type polyisocyanate, an isophorone diisocyanate-type polyisocyanate, a phenol novolac-type epoxy resin, a cresol novolac-type epoxy resin, and epoxidized polybutadiene.

When the stabilizer (B1) and the stabilizer (B2) are used in combination as the stabilizer (B), the stabilizer (B) preferably includes a large amount of the stabilizer (B1) from a viewpoint of improving transparency.

Specifically, with respect to 100 parts by mass of the stabilizer (B1), the amount of the stabilizer (B2) is preferably in a range of from 10 parts by mass to 150 parts by mass, and more preferably in a range of from 50 parts by mass to 100 parts by mass from a viewpoint of coexistence of transparency and moist heat resistance.

When the polymeric piezoelectric body according to the invention includes the stabilizer (B), the content of the stabilizer (B) is preferably from 0.01 parts by mass to 10 parts by mass with respect to 100 parts by mass of the aliphatic polyester (A).

The above content is preferably 2.8 parts by mass or less from a viewpoint of transparency.

The above content is more preferably 0.7 parts by mass or more in order to obtain higher reliability. The above content is still more preferably 1.5 parts by mass or more from a viewpoint of further improving moist heat resistance.

<Other Components>

The polymeric piezoelectric body according to the invention may contain, to an extent that the effect of the invention is not impaired, other components such as publicly known resins represented by polyvinylidene fluoride, a polyethylene resin, and a polystyrene resin, inorganic fillers including silica, hydroxyapatite, and montmorillonite, and publicly known crystal nucleating agents including phthalocyanine.

For other components including inorganic fillers and crystal nucleating agents, it is possible to refer to the description of paragraphs 0057 to 0060 of WO 2013/054918 A, if appropriate.

When the polymeric piezoelectric body contains components other than the aliphatic polyester (A), the content

of the components other than the aliphatic polyester (A) is preferably 20% by mass or less, and more preferably 10% by mass or less with respect to the total mass of the polymeric piezoelectric body.

<Crystallinity>

The polymeric piezoelectric body according to the invention has crystallinity obtained by a DSC method (differential scanning heat analysis method), of from 20% to 80%.
When the crystallinity is less than 20%, piezoelectricity (piezoelectric constant) or strength of the polymeric piezoelectric body tends to be insufficient.
When the crystallinity is more than 80%, transparency of the polymeric piezoelectric body tends to be insufficient (that is, internal haze is increased).
The crystallinity of from 20% to 80% is advantageous also in improving in-plane uniformity of internal haze.
The crystallinity is preferably from 30% to 70%.

<Piezoelectric Constant $d_{14}$ (Stress-Charge Method)>

The polymeric piezoelectric body according to the invention preferably has a piezoelectric constant $d_{14}$ measured at 25°C by a stress-charge method, of 1 pC/N or more.
Hereinafter, "piezoelectric constant $d_{14}$ measured at 25°C by a stress-charge method" is also simply referred to as "piezoelectric constant $d_{14}$" or "piezoelectric constant".
Hereinafter, an example of a method of measuring the piezoelectric constant $d_{14}$ by a stress-charge method will be described.
First, a polymeric piezoelectric body is cut to a length of 150 mm in the direction of 45° with respect to the stretching direction (for example, MD direction) of the polymeric piezoelectric body, and to 50 mm in the direction perpendicular to the above 45° direction, to prepare a rectangular specimen. Subsequently, the prepared specimen is set on a stage of Showa Shinku SIP-600, and aluminum (hereinafter, referred to as Al) is deposited on one surface of the specimen such that the deposition thickness of Al becomes about 50 nm. Subsequently, Al is deposited on the other surface of the specimen similarly. Both surfaces of the specimen are covered with Al to form conductive layers of Al.
The specimen of 150 mm×50 mm having the Al conductive layers formed on both surfaces is cut to a length of 120 mm in the direction of 45° with respect to the stretching direction (for example, MD direction) of the polymeric piezoelectric body, and to 10 mm in the direction perpendicular to the above 45° direction, to cut out a rectangular film of 120 mm×10 mm. This film is used as a sample for measuring a piezoelectric constant.
The sample thus obtained is set in a tensile testing machine (TENSILON RTG-1250 manufactured by A&D Company, Limited) having a distance between chucks, of 70 mm so as not to be slack. A force is applied periodically at a crosshead speed of 5 mm/min such that the applied force reciprocates between 4 N and 9 N. In order to measure a charge amount generated in the sample according to the applied force at this time, a capacitor having an electrostatic capacity Qm (F) is connected in parallel to the sample, and a voltage V between the terminals of this capacitor Cm (95 nF) is measured through a buffer amplifier. The above measurement is performed under a temperature condition of 25°C. A generated charge amount Q (C) is calculated as a product of the capacitor capacity Cm and a voltage Vm between the terminals. The piezoelectric constant $d_{14}$ is calculated by the following formula.

$$d_{14} = (2 \times t)/L \times Cm \cdot \Delta Vm/\Delta F$$

t: sample thickness (m)
L: distance between chucks (m)
Cm: capacity (F) of capacitor connected in parallel
ΔVm/ΔF: ratio of change amount of voltage between terminals of capacitor with respect to change amount of force

A higher piezoelectric constant $d_{14}$ results in a larger displacement of the polymeric piezoelectric body with respect to a voltage applied to the polymeric piezoelectric body, and reversely a higher voltage generated responding to a force applied to the polymeric piezoelectric body, and therefore is advantageous as a polymeric piezoelectric body.
Specifically, in the polymeric piezoelectric body according to the invention, the piezoelectric constant $d_{14}$ measured at 25°C by a stress-charge method is preferably 1 pC/N or more, more preferably 3 pC/N or more, still more preferably 4 pC/N or more. The upper limit of the piezoelectric constant $d_{14}$ is not particularly limited, and is preferably 50 pC/N or less, and more preferably 30 pC/N or less, for a polymeric piezoelectric body using a helical chiral polymer from a viewpoint of a balance with transparency, or the like described below.

Similarly, from a viewpoint of the balance with transparency, the piezoelectric constant $d_{14}$ measured by a resonance method is preferably 15 pC/N or less.

Here, the "MD direction" is a direction (Machine Direction) in which a film flows, and a "TD direction" is a direction (Transverse Direction) perpendicular to the MD direction and parallel to a principal plane of the film.

<Standardized Molecular Orientation MORc>

The polymeric piezoelectric body according to the invention preferably has a standardized molecular orientation MORc of from 2.0 to 10.0.

When the standardized molecular orientation MORc is within a range of from 2.0 to 10.0, a high strength of the film is maintained, and reduction in the strength of the film in a specific direction (for example, a direction perpendicular to a main stretching direction in a surface of the film) is suppressed.

In addition, when MORc is within the above range, many polymeric piezoelectric bodies are arranged in the stretching direction. As a result, a ratio of generating oriented crystals becomes higher, and it is possible to exhibit a high piezoelectricity.

Before the standardized molecular orientation MORc is described, a molecular orientation ratio MOR will be described.

The molecular orientation ratio MOR is a value indicating a degree of molecular orientation, and measured by the following microwave measurement method.

That is, a sample (film) is placed in a microwave resonant waveguide of a well-known microwave molecular orientation ratio measuring apparatus (also referred to as a "microwave transmission-type molecular orientation meter") such that the sample surface (film surface) is perpendicular to a traveling direction of the microwaves. Then, while the sample is continuously irradiated with microwaves an oscillating direction of which is biased unidirectionally, the sample is rotated in a plane perpendicular to the traveling direction of the microwaves from 0 to 360°, and the intensity of the microwaves which have passed through the sample is measured to determine the molecular orientation ratio MOR.

The standardized molecular orientation MORc means a MOR value obtained based on the reference thickness tc of 50 μm, and can be determined by the following formula.

$$\mathrm{MORc} = (\mathrm{tc}/\mathrm{t}) \times (\mathrm{MOR} - 1) + 1$$

(tc: reference thickness to which the thickness should be corrected; t: sample thickness)

The standardized molecular orientation MORc can be measured by a publicly known molecular orientation meter, for example, a microwave molecular orientation meter MOA-2012A or MOA-6000 manufactured by Oji Scientific Instruments, at a resonance frequency around 4 GHz or 12 GHz.

The standardized molecular orientation MORc can be controlled by conditions of crystallization (for example, heating temperature and heating time) and stretching conditions (for example, stretching temperature and stretching speed) when the polymeric piezoelectric body is manufactured.

The standardized molecular orientation MORc can be converted to birefringence Δn which is obtained by dividing retardation by a film thickness.

Specifically, the retardation can be measured by a RETS 100 manufactured by Otsuka Electronics Co., Ltd. MORc and Δn are approximately in a linearly proportional relationship. When Δn is 0, MORc is 1.

For example, when the polymer (A) is a polylactic acid-type polymer and the birefringence Δn is measured at measurement wavelength of 550 nm, the lower limit 2.0 of a preferable range for the standardized molecular orientation MORc can be converted to the birefringence Δn of 0.005. The lower limit 40 of a preferable range of a product of the standardized molecular orientation MORc and the crystallinity of the polymeric piezoelectric body can be converted to 0.1 as a product of the birefringence Δn and the crystallinity of the polymeric piezoelectric body.

<Product of Standardized Molecular Orientation MORc and Crystallinity>

The product of the standardized molecular orientation MORc and the crystallinity of the polymeric piezoelectric body is preferably from 25 to 700, more preferably from 40 to 700, still more preferably from 75 to 680, further still more preferably from 90 to 660, particularly preferably from 125 to 650, and most preferably from 180 to 350.

When the above product is within a range of from 25 to 700, transparency and dimensional stability are maintained suitably. Furthermore, piezoelectricity of the polymeric piezoelectric body is also maintained suitably.

In the invention, it is possible to adjust the product of the crystallinity and the standardized molecular orientation MORc of the polymeric piezoelectric body within the above range, for example, by adjusting the conditions of crystallization

and stretching when the polymeric piezoelectric body is manufactured.

<Internal Haze>

Transparency of the polymeric piezoelectric body can be evaluated, for example, by visual observation or measurement of haze.
The internal haze of the polymeric piezoelectric body with respect to visible light is preferably 50% or less. Here, the internal haze is a value obtained when a haze of a polymeric piezoelectric body having a thickness of from 0.03 mm to 0.05 mm is measured in accordance with JIS-K7105 using a haze measuring machine [TC-HIII DPK manufactured by Tokyo Denshoku Co., Ltd.,] at 25°C. Details of the measurement method will be described in Examples.
Furthermore, the internal haze of the polymeric piezoelectric body is preferably 40% or less, more preferably 20% or less, still more preferably 13% or less, and further still more preferably 5% or less. Furthermore, the internal haze of the polymeric piezoelectric body is preferably 2.0% or less, and particularly preferably 1.0% or less from a viewpoint of further improving longitudinal tear strength.
The lower the internal haze of the polymeric piezoelectric body is, the better the polymeric piezoelectric body is. From a viewpoint of the balance with the piezoelectric constant, *etc.* the internal haze is preferably from 0.0% to 40%, more preferably 0.01% to 20%, still more preferably 0.01% to 5%, further still more preferably 0.01 % to 2.0%, and particularly preferably 0.01% to 1.0%.
The "internal haze" of the polymeric piezoelectric body referred to in the present application is a haze from which a haze caused by the shape of an external surface of the polymeric piezoelectric body is excluded, as described in Examples below.

<Thickness>

The thickness of the polymeric piezoelectric body according to the invention is not particularly limited, for example, can be from 10 μm to 1000 μm, and is preferably from 10 μm to 400 μm, more preferably from 20 μm to 200 μm, still more preferably from 20 μm to 100 μm, and particularly preferably from 30 μm to 80 μm.

<Method of Manufacturing Polymeric Piezoelectric Body>

A method of manufacturing the polymeric piezoelectric body according to the invention is not particularly limited. For example, it is possible to refer to the description of paragraphs 0065 to 0099 of WO 2013/054918 A, if appropriate.
That is, examples of a preferable method of manufacturing the polymeric piezoelectric body according to the invention include a method of manufacturing a polymeric piezoelectric body, including a first step for obtaining a pre-crystallized film containing the polymer (A) and the stabilizer (B) and a second step for stretching the pre-crystallized film mainly uniaxially (in addition, a step for performing an annealing treatment, if necessary).
Other examples of a preferable manufacturing method include a method of manufacturing a polymeric piezoelectric body, including a step for stretching a film containing the polymer (A) and the stabilizer (B) mainly uniaxially and a step for performing an annealing treatment in this order.

[Use of Layered body]

The layered body of the invention can be used in various fields including a speaker, a headphone, a touch panel, a remote controller, a microphone, a hydrophone, an ultrasonic transducer, an ultrasonic applied measurement instrument, a piezoelectric vibrator, a mechanical filter, a piezoelectric transformer, a delay unit, a sensor, an acceleration sensor, an impact sensor, a vibration sensor, a pressure-sensitive sensor, a tactile sensor, an electric field sensor, a sound pressure sensor, a display, a fan, a pump, a variable-focus mirror, a sound insulation material, a soundproof material, a keyboard, an acoustic equipment, an information processing equipment, a measurement equipment, and a medical appliance.
The layered body of the invention is suitably used as a piezoelectric device further including an electrode and including a polymeric piezoelectric body, the layer (X), and an electrode in this order.
This piezoelectric device may include a component other than the above components, and may include, for example, a polymer film or glass between the layer (X) and the electrode.
Examples of a material (polymer) of the polymer film are as described above.
Examples of a material of the electrode, examples of a structure of the electrode, and examples of a laminated structure of the piezoelectric device (layered body) are also as described above.
The polymeric piezoelectric body according to the invention and an electrode may be repeatedly laminated on each other, and the layer (X) may be interposed between at least some of the piezoelectric bodies and the electrodes

to be used as a laminated piezoelectric element.

For example, units of an electrode and the polymeric piezoelectric body having the layers (X) on both surfaces thereof are repeatedly laminated on each other, and finally a principal plane of the polymeric piezoelectric body not covered with an electrode is covered with an electrode. Specifically, a laminated piezoelectric element having two repeated units can be a laminated piezoelectric element having an electrode, a layer (X), a polymeric piezoelectric body, a layer (X), an electrode, a layer (X), a polymeric piezoelectric body, a layer (X), and an electrode laminated in this order. As for the polymeric piezoelectric body used for a laminated piezoelectric element, at least one layer of polymeric piezoelectric body and one layer (X) are only required to be the layered body of the invention, and other layers are need not be the layer (X) or the polymeric piezoelectric body in the layered body of the invention.

In a case in which a plurality of laminated bodies of the invention are included in a laminated piezoelectric element, when the aliphatic polyester (A) contained in a polymeric piezoelectric body in a layer has L-form optical activity, the aliphatic polyester (A) contained in a polymeric piezoelectric body in another layer may be either L-form or D-form. The arrangement of polymeric piezoelectric bodies can be adjusted according to a use of a piezoelectric element, if appropriate.

As the electrode, a transparent electrode is preferable.

Here, a transparent electrode specifically means that its internal haze is 40% or less (total luminous transmittance is 60% or more).

The piezoelectric element using the layered body of the invention may be applied to the above various piezoelectric devices including a speaker and a touch panel. Particularly, a piezoelectric element including a transparent electrode is suitable for application to a speaker, a touch panel, an actuator, or the like.

[Examples]

Hereinafter, the embodiment of the invention will be described more specifically by way of Examples. The present embodiment is not limited to the following Examples as long as the present embodiment departs from the gist of the invention.

<Manufacturing Piezoelectric Body>

[Manufacturing Piezoelectric Body A] To 100 parts by mass of a polylactic acid (registered trade mark Ingeo4032D) manufactured by NatureWorks LLC., 1.0 part by mass of the following additive X was added and dry blended to prepare a raw material.

The prepared raw material was put into an extruder hopper, was extruded from a T-die while being heated to a temperature of from 220°C to 230°C, and was brought into contact with a cast roll at 50°C for 0.3 minutes to form a pre-crystallized film having a thickness of 150 μm (pre-crystallization step). The crystallinity of the pre-crystallized film was measured, and the crystallinity was 6%.

Stretching of the obtained pre-crystallized film was started at a stretching speed of 3 m/min by roll-to-roll while the film was heated at 70°C, and the film was stretched up to 3.5-fold uniaxially in the MD direction (stretching step). The thickness of the obtained film was 47.2 μm.

Thereafter, the uniaxially stretched film was brought into contact with a roll heated to 145°C for 15 seconds by roll-to-roll, and was subjected to an annealing treatment. Thereafter, the film was subjected to rapid cooling to manufacture a polymeric piezoelectric body (piezoelectric body) (annealing treatment step).

-Additive X-

As the additive X, a mixture of Stabaxol P400 (20 parts by mass) manufactured by Rhein Chemie GmbH, Stabaxol I (50 parts by mass) manufactured by Rhein Chemie GmbH, and CARBODILITE LA-1 (30 parts by mass) manufactured by Nisshinbo Chemical Inc. was used.

Details of the components in the above mixture are as follows.

Stabaxol I ... bis-2,6-diisopropylphenyl carbodiimide (molecular weight (= weight average molecular weight): 363)
Stabaxol P400 ... poly(1,3,5-triisopropylphenylene-2,4-carbodiimide) (weight average molecular weight: 20,000)
Carbodilite LA-1 ... poly(4,4'-dicyclohexylmethane carbodiimide) (weight average molecular weight: about 2,000)

[Manufacturing Piezoelectric Body B]

A piezoelectric body B was manufactured in a similar manner to manufacturing the piezoelectric body A except that the addition amount of the additive X was changed to 2 parts by mass with respect to 100 parts by mass of a

polylactic acid.

[Measurement of Physical Properties of Piezoelectric Body]

As for the piezoelectric bodies obtained above (piezoelectric body A and piezoelectric body B), chirality, the weight average molecular weight (Mw), the molecular weight distribution (Mw/Mn), the optical purity, the melting point (Tm), the crystallinity, the thickness, the standardized molecular orientation MORc (reference thickness 50 μm), the in-plane phase difference, the birefringence, the internal haze, the piezoelectric constant $d_{14}$, and the product of the standardized molecular orientation MORc and the crystallinity were measured. Results are shown in Table 1.

Specifically, the measurements were performed as follows.

(Mw, Mw/Mn, Optical Purity, and Chirality)

Mw, Mw/Mn, the optical purity, and the chirality of a polylactic acid contained in the piezoelectric body were measured by a method described in paragraphs 0126 to 0128 of WO 2013/054918 A.

(Melting Point, Crystallinity)

10 mg of the polymeric piezoelectric body was accurately weighed. The temperature thereof was raised to 140°C at a temperature rising rate of 500°C/min, and was further raised to 200°C at a temperature rising rate of 10°C/min using a differential scanning calorimeter (DSC-1 manufactured by Perkin Elmer Co., Ltd.) to obtain a melting curve. The melting point Tm and the crystallinity were obtained from the resulting melting curve.

(Standardized Molecular Orientation MORc)

The standardized molecular orientation MORc was measured by a microwave molecular orientation meter MOA-6000 by Oji Scientific Instruments Co., Ltd. The reference thickness tc was set to 50 μm.

(In-plane Phase Difference and Birefringence)

The in-plane phase difference (phase difference in the in-plane direction) Re was measured under the following measurement conditions. The birefringence is represented by a value obtained by dividing the in-plane phase difference by a thickness of the piezoelectric body.

- Measuring wavelength ... 550 nm
- Measuring apparatus ... phase difference film and optical material inspection equipment RETS-100 manufactured by OTSUKA ELECTRONICS Co., Ltd.

(Internal Haze)

The internal haze value of the piezoelectric body was measured by measuring light transmittance in the thickness direction using the following apparatus under the following measuring conditions.

More specifically, the haze (H2) was measured by interposing in advance only silicone oil (Shin-Etsu Silicone (trade mark), model number: KF96-100CS manufactured by Shin-Etsu Chemical Co., Ltd.) between two glass plates, and then the haze (H3) was measured by interposing a piezoelectric body a surface of which was uniformly coated with the silicone oil between the two glass plates. The internal haze (H1) of the piezoelectric body in the present Example was obtained by calculating the difference between the two values according to the following formula.

$$\text{Internal haze (H1)} = \text{haze (H3)} - \text{haze (H2)}$$

The haze (H2) and the haze (H3) were measured by measuring the light transmittance in the thickness direction using the following apparatus under the following measuring conditions.

Measuring apparatus: HAZE METER TC-HIIIDPK (manufactured by Tokyo Denshoku Co., LTD.)
Sample size: width 3 mm × length 30 mm, thickness 0.05 mm
Measuring conditions: According to JIS-K7105

Measuring temperature: Room temperature (25°C)

(Piezoelectric Constant $d_{14}$ (Stress-Charge Method))

The piezoelectric constant $d_{14}$ of a piezoelectric body was measured by the above measuring method (stress-charge method).

[Table 1]

| | piezoelectric body A | piezoelectric body B |
|---|---|---|
| resin | LA | LA |
| chirality | L | L |
| Mw | 230,000 | 230,000 |
| Mw/Mn | 1.83 | 1.83 |
| optical purity (%ee) | 97 | 97 |
| Tm (°C) | 165.4 | 164.8 |
| amount of additive X (parts by mass) | 1 | 2 |
| crystallinity (%) | 40.5 | 39.4 |
| thickness (μm) | 47.2 | 48.7 |
| MORc [50 μm] | 4.82 | 4.91 |
| in-plane phase difference (nm) | 1028 | 1071 |
| birefringence | 0.0218 | 0.0220 |
| internal haze (%) | 0.2 | 0.2 |
| piezoelectric constant (pC/N) | 6.21 | 6.11 |
| MORc × crystallinity | 195 | 193 |

[Example 1]

<Manufacturing Layered body (Five-Layer Layered body)>

The piezoelectric body B was cut to a length of 150 mm in the direction of 45° with respect to the stretching direction (MD direction), and to a length of 50 mm in the direction perpendicular to the above 45° direction, to cut out a specimen from the piezoelectric body B.

Subsequently, an optical transparent pressure sensitive adhesive sheet "LUCIACS CS9661 TS" (layered body having a three-layer structure of a PET film having a thickness of 50 μm/an acrylic resin type pressure sensitive adhesive layer having a thickness of 25 μm (hereinafter, also referred to as "pressure sensitive adhesive layer B")/a PET film having a thickness of 50 μm) manufactured by Nitto Denko Corporation was cut out to the same size as the above specimen. Subsequently, one PET film was peeled and removed to thereby prepare a layered body having a two-layer structure of a pressure sensitive adhesive layer B/a PET film. Two laminated bodies each having this two-layer structure were prepared.

Subsequently, the above laminated bodies each having the two-layer structure were stuck to both surfaces of the specimen (piezoelectric body B) cut out above such that the pressure sensitive adhesive layer B comes into contact with the piezoelectric body B. At this time, the piezoelectric body B, the two pressure sensitive adhesive layers B, and the two PET films were stuck such that the respective centers and outer peripheries were overlapped one another.

In this way, a layered body having a five-layer structure of a PET film/a pressure sensitive adhesive layer B/a piezoelectric body B/a pressure sensitive adhesive layer B/a PET film (hereinafter, also referred to as layered body (five layer)) was obtained.

The acid value of the pressure sensitive adhesive layer B was measured by the above method, and a result is shown in Table 2. The acid value was measured by dissolving the pressure sensitive adhesive layer B in chloroform.

<Evaluation>

The following evaluation of the piezoelectric body B and the five-layer layered body obtained above was performed.

Evaluation results are shown in Table 2 below.

(Adhesion)

Adhesion between the piezoelectric body B and the pressure sensitive adhesive layer B was evaluated by measuring peeling strength between the piezoelectric body B and the pressure sensitive adhesive layer B by the following method. Needless to say, the higher the peel strength is, the better the adhesion is (the larger an adhesive force is).

-Method of measuring peeling strength-

Two specimens each having a size of 150 mm in the stretching direction (MD direction) and 25 mm in the direction perpendicular to the stretching direction, were cut out from the piezoelectric body B.

Subsequently, the above "LUCIACS CS9661TS" was cut to a size of 100 mm × 25 mm. (Two) PET films on both surfaces were peeled and removed from the cut "LUCIACS CS9661 TS", and the above specimens (piezoelectric bodies B) were stuck to both surfaces of the pressure sensitive adhesive layer B. At this time, as illustrated in Fig. 1, two piezoelectric bodies B (piezoelectric body 11 in Fig. 1) and one pressure sensitive adhesive layer B (pressure sensitive adhesive layer 12 in Fig. 1) were stuck to each other so as to be overlapped at one end thereof in the long-side direction (Fig. 1) and to be overlapped at both ends thereof in the width direction. Here, Fig .1 schematically illustrates a cross section cut by a plane parallel to a longitudinal direction and a thickness direction of a three-layer layered body.

In this way, a layered body (hereinafter, also referred to as three-layer layered body) having a laminated structure of a piezoelectric body B/a pressure sensitive adhesive layer B/a piezoelectric body B was obtained.

Subsequently, T-peeling strength between the piezoelectric body B and the pressure sensitive adhesive layer B in the three-layer layered body obtained above was measured in accordance with JIS-K6854-3 using a tensile testing machine (TENSILON RTG-1250 manufactured by A&D Company, Limited).

(Weight Average Molecular Weight (Mw) and Piezoelectric Constant $d_{14}$ Before Reliability Test)

The two PET films and the two pressure sensitive adhesive layers B were peeled from the above five-layer layered body to thereby take out the piezoelectric body B from the layered body.

Subsequently, the weight average molecular weight (Mw) and the piezoelectric constant $d_{14}$ of the piezoelectric body B thus taken out were measured in a similar manner to the above.

(Weight Average Molecular Weight (Mw) and Piezoelectric Constant $d_{14}$ After Reliability Test)

The above five-layer layered body was stored at a high temperature and a high humidity (hereinafter, referred to as "reliability test").

Subsequently, the two PET films and the two pressure sensitive adhesive layers B were peeled from the five-layer layered body after the reliability test to thereby take out the piezoelectric body B from the layered body.

Subsequently, the weight average molecular weight (Mw) and the piezoelectric constant $d_{14}$ of the piezoelectric body B thus taken out were measured in a similar manner to the above.

The reliability test was performed under two conditions of 60°C 95%RH for 504 hours and 85°C 85%RH for 240 hours.

[Comparative Example 1]

Evaluation was performed in a similar manner to Example 1 except that the piezoelectric body B was changed to the piezoelectric body A and "LUCIACS CS9661 TS" was changed to an optical transparent pressure sensitive adhesive sheet "LUCIACS CS9621T" (layered body having a three-layer structure of a PET film having a thickness of 50 μm/an acrylic resin type pressure sensitive adhesive layer having a thickness of 25 μm (hereinafter, also referred to as "pressure sensitive adhesive layer A")/a PET film having a thickness of 50 μm) manufactured by Nitto Denko Corporation in Example 1. The acid value of the pressure sensitive adhesive layer A was measured by the above method, and a result is shown in Table 2.

Evaluation results are shown in Table 2 below.

[Comparative Example 2]

Evaluation was performed in a similar manner to Comparative Example 1 except that the piezoelectric body A was changed to the piezoelectric body B in Comparative Example 1.

Evaluation results are shown in Table 2 below.

[Table 2]

| | piezoelectric body | pressure sensitive adhesive layer | | before reliability test | | | after reliability test (60°C 95%RH for 504 hours) | | | after reliability test (85°C 85%RH for 240 hours) | | |
|---|---|---|---|---|---|---|---|---|---|---|---|---|
| | | kind | acid value (mgKOH/g) | peeling strength (N/25 mm) | Mw | piezoelectric constant (pC/N) | Mw | Mw change ratio | piezoelectric constant (pC/N) | Mw | Mw change ratio | piezoelectric constant (pC/N) |
| Example 1 | B | B | 0.4 | 1.3 | 225620 | 6.11 | 228200 | 1.01 | 6.58 | 164970 | 0.73 | 6.93 |
| Comparative Example 1 | A | A | 35.8 | 1.7 | 229130 | 6.21 | 216020 | 0.94 | 6.79 | 5820 | 0.03 | impossible to measure |
| Comparative Example 2 | B | A | 35.8 | 1.6 | 227210 | 6.11 | 232440 | 1.02 | 6.67 | 7920 | 0.03 | impossible to measure |

As shown in Table 2, in Example 1 in which the acid value of the pressure sensitive adhesive layer was 10 mgKOH/g or less, the Mw change ratio of a polylactic acid was maintained highly to some extent and the high piezoelectric constant of the piezoelectric body was maintained after the reliability test. Furthermore, in Example 1, adhesion between the piezoelectric body and the pressure sensitive adhesive layer was excellent.

In Comparative Examples 1 and 2 in which the acid value of the pressure sensitive adhesive layer was more than 10 mgKOH/g, the Mw change ratio was largely reduced particularly after the reliability test at 85°C 85%RH for 240 hours, the polylactic acid was decomposed, and the weight average molecular weight (Mw) of the polylactic acid was reduced. Therefore, the piezoelectric body was deteriorated and broken, and it was not possible to measure the piezoelectric constant.

[Examples 2 to 5]

In Examples 2 to 5, the piezoelectric body A was prepared as a polymeric piezoelectric body, and a five-layer layered body was manufactured in a similar manner to Example 1 using the following pressure sensitive adhesive sheets as pressure sensitive adhesive layers B to E. The pressure sensitive adhesive sheets used as the pressure sensitive adhesive layers B to E are as follows.

Pressure sensitive adhesive layer B: optical transparent pressure sensitive adhesive sheet "LUCIACS CS9661TS" manufactured by Nitto Denko Corporation
Pressure sensitive adhesive layer C: highly transparent double-sided tape "5402A" manufactured by Sekisui Chemical Co., Ltd.
Pressure sensitive adhesive layer D: highly transparent pressure sensitive adhesive transfer tape "8146-1" manufactured by 3M Company
Pressure sensitive adhesive layer E: "OAD-CF" manufactured by TOYOHOZAI Co., Ltd.

(Acid Values and Total Amounts of Nitrogen of Pressure Sensitive Adhesive Layers B to E)

The acid values and total amounts of nitrogen of the pressure sensitive adhesive layers B to E were measured, and results are shown in Table 3. The total amounts of nitrogen of the pressure sensitive adhesive layers B to E were measured using a CHN elemental analyzer 2400II type manufactured by Perkin Elmer Co., Ltd.

Peeling strength between the piezoelectric body A and each of the pressure sensitive adhesive layers B to E was measured by the above method to evaluate adhesion between the piezoelectric body A and each of the pressure sensitive adhesive layers B to E.

The weight average molecular weight (Mw) and the piezoelectric constant $d_{14}$ before the reliability test, and the weight average molecular weight (Mw) and the piezoelectric constant $d_{14}$ after the reliability test were measured by the above method. The reliability test was performed at 85°C 85%RH for 120 hours.

Evaluation results are shown in Table 3 below.

[Table 3]

| | piezoelectric body | pressure sensitive adhesive layer | | | before reliability test | | | after reliability test (85°C 85%RH for 120 hours) | | |
|---|---|---|---|---|---|---|---|---|---|---|
| | | kind | acid value (mgKOH/g) | total amount of nitrogen (wt%) | peeling strength (N/25 mm) | Mw | piezoelectric constant (pC/N) | Mw | Mw change ratio | piezoelectric constant (pC/N) |
| Example 2 | A | B | 0.4 | 1.0 | 1.2 | 221930 | 6.21 | 152170 | 0.69 | 6.97 |
| Example 3 | A | C | 0.2 | 1.6 | 1.7 | 223110 | 6.21 | 157620 | 0.71 | 6.82 |
| Example 4 | A | D | 0.2 | less than 0.3 | 1.3 | 227190 | 6.21 | 137630 | 0.61 | 6.87 |
| Example 5 | A | E | 0.3 | 2.8 | 1.6 | 219740 | 6.21 | 190700 | 0.87 | 6.91 |

Table 3 indicates that peeling strength is improved and adhesion is enhanced by increase in the total amount of nitrogen in the pressure sensitive adhesive layer and that the piezoelectric body maintains a high piezoelectric constant even when the total amount of nitrogen is increased.

Japanese Patent Application No 2013-181698 is being referred to.

Reference Signs List

11 piezoelectric body (polymeric piezoelectric body)
12 pressure sensitive adhesive layer (layer (X))

## Claims

1. A layered body comprising:

   a polymeric piezoelectric body) (11) which contains an optically active aliphatic polyester

   (A) having a weight average molecular weight of from 50,000 to 1,000,000 and has crystallinity obtained by a DSC method, of from 20% to 80%; and **characterized by** a layer (12) which is in contact with the polymeric piezoelectric body and has an acid value of 10 mgKOH/g or less.

2. The layered body according to claim 1, wherein the layer (12) is an adhesive layer, a pressure sensitive adhesive layer, a hard coat layer, an antistatic layer, an antiblock layer, or a refractive index adjusting layer.

3. The layered body according to claim 1 or 2, wherein the layer (12) is a pressure sensitive adhesive layer or an adhesive layer.

4. The layered body according to any one of Claims 1 to 3, wherein the acid value of the layer (12) is 0.01 mgKOH/g or more.

5. The layered body according to any one of Claims 1 to 4, wherein a total amount of nitrogen in the layer (12) is from 0.05% by mass to 10% by mass.

6. The layered body according to any one of Claims 1 to 5, wherein the polymeric piezoelectric body includes from 0.01 parts by mass to 10 parts by mass of a stabilizer (B), which has at least one functional group selected from the group consisting of a carbodiimide group, an epoxy group, and an isocyanate group, and has a weight average molecular weight of from 200 to 60,000, with respect to 100 parts by mass of the aliphatic polyester (A).

7. The layered body according to claim 6, wherein the stabilizer (B) includes a stabilizer (B1), which has at least one functional group selected from the group consisting of a carbodiimide group, an epoxy group, and an isocyanate group, and has a weight average molecular weight of from 200 to 900, and wherein the stabilizer (B) includes a stabilizer (B2) which has, in one molecule, two or more functional groups of one or more kinds selected from the group consisting of a carbodiimide group, an epoxy group, and an isocyanate group, and has a weight average molecular weight of from 1,000 to 60,000.

8. The layered body according to any one of Claims 1 to 7, wherein the polymeric piezoelectric body has an internal haze with respect to visible light, of 50% or less, and a piezoelectric constant $d_{14}$ measured at 25°C by a stress-charge method, of 1 pC/N or more.

9. The layered body according to any one of Claims 1 to 8, wherein the polymeric piezoelectric body has an internal haze with respect to visible light, of 13% or less, and includes from 0.01 parts by mass to 2.8 parts by mass of a stabilizer (B), which has at least one functional group selected from the group consisting of a carbodiimide group, an epoxy group, and an isocyanate group, and has a weight average molecular weight of from 200 to 60,000, with respect to 100 parts by mass of the aliphatic polyester (A).

10. The layered body according to any one of Claims 1 to 9, wherein the polymeric piezoelectric body has a product of

the crystallinity and a standardized molecular orientation MORc measured by a microwave transmission-type molecular orientation meter based on a reference thickness of 50 μm, of from 25 to 700.

**11.** The layered body according to any one of Claims 1 to 10, wherein the aliphatic polyester (A) is a polylactic acid polymer having a main chain containing a repeating unit represented by the following Formula (1)

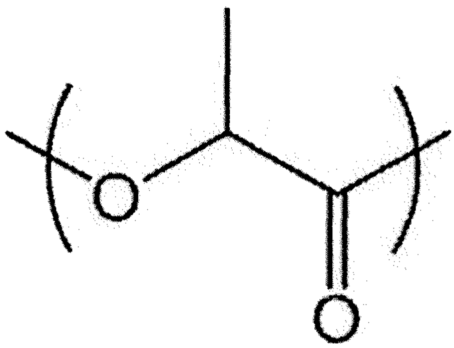

(1)

.

**12.** The layered body according to any one of Claims 1 to 11, wherein the aliphatic polyester (A) has an optical purity of 95.00%ee or more.

**13.** The layered body according to any one of Claims 1 to 12, wherein a content of the aliphatic polyester (A) in the polymeric piezoelectric body is 80% by mass or more.

**Patentansprüche**

**1.** Schichtkörper, umfassend:

einen polymeren piezoelektrischen Körper (11), der einen optisch aktiven aliphatischen Polyester (A) mit einem gewichtsmittleren Molekulargewicht von 50.000 bis 1.000.000 und einer nach einem DSC-Verfahren erhaltenen Kristallinität von 20% bis 80% enthält; und

**gekennzeichnet durch** eine Schicht (12), die mit dem polymeren piezoelektrischen Körper in Kontakt steht und eine Säurezahl von 10 mgKOH/g oder weniger aufweist.

**2.** Schichtkörper gemäß Anspruch 1, wobei die Schicht (12) eine Klebeschicht, eine Haftklebeschicht, eine Hartbeschichtungsschicht, eine Antistatikschicht, eine Antiblockschicht oder eine Brechungsindex-Einstellschicht ist.

**3.** Schichtkörper gemäß Anspruch 1 oder 2, wobei die Schicht (12) eine Haftklebeschicht oder eine Klebeschicht ist.

**4.** Schichtkörper gemäß einem der Ansprüche 1 bis 3, wobei die Säurezahl der Schicht (12) 0,01 mgKOH/g oder mehr ist.

**5.** Schichtkörper gemäß einem der Ansprüche 1 bis 4, wobei die Gesamtmenge an Stickstoff in der Schicht (12) 0,05 Massen-% bis 10 Massen-% beträgt.

**6.** Schichtkörper gemäß einem der Ansprüche 1 bis 5, wobei der polymere piezoelektrische Körper, bezogen auf 100 Massenteile des aliphatischen Polyesters (A), 0,01 Massenteile bis 10 Massenteile eines Stabilisators (B) enthält, der mindestens eine funktionelle Gruppe, ausgewählt aus der Gruppe, bestehend aus einer Carbodiimidgruppe, einer Epoxygruppe und einer Isocyanatgruppe, aufweist und ein gewichtsmittleres Molekulargewicht von 200 bis 60.000 aufweist.

**7.** Schichtkörper gemäß Anspruch 6, wobei der Stabilisator (B) einen Stabilisator (B1) enthält, der mindestens eine funktionelle Gruppe, ausgewählt aus der Gruppe, bestehend aus einer Carbodiimidgruppe, einer Epoxygruppe und einer Isocyanatgruppe, aufweist und ein gewichtsmittleres Molekulargewicht von 200 bis 900 aufweist, und wobei der Stabilisator (B) einen Stabilisator (B2) enthält, der in einem Molekül zwei oder mehr funktionelle Gruppen von einer oder mehreren Sorten, die aus der Gruppe, bestehend aus einer Carbodiimidgruppe, einer Epoxygruppe und

einer Isocyanatgruppe, ausgewählt sind, aufweist und ein gewichtsmittleres Molekulargewicht von 1.000 bis 60.000 aufweist.

**8.** Schichtkörper gemäß einem der Ansprüche 1 bis 7, wobei der polymere piezoelektrische Körper in Bezug auf sichtbares Licht eine innere Trübung von 50% oder weniger und eine Piezoelektrizitätskonstante $d_{14}$, gemessen bei 25°C durch ein Spannungsbelastungsverfahren, von 1 pC/N oder mehr aufweist.

**9.** Schichtkörper gemäß einem der Ansprüche 1 bis 8, wobei der polymere piezoelektrische Körper in Bezug auf sichtbares Licht eine innere Trübung von 13% oder weniger aufweist und, bezogen auf 100 Massenteile des aliphatischen Polyesters (A), 0,01 Massenteile bis 2,8 Massenteile eines Stabilisators (B) enthält, der mindestens eine funktionelle Gruppe, ausgewählt aus der Gruppe, bestehend aus einer Carbodiimidgruppe, einer Epoxygruppe und einer Isocyanatgruppe, aufweist und ein gewichtsmittleres Molekulargewicht von 200 bis 60.000 aufweist.

**10.** Schichtkörper gemäß einem der Ansprüche 1 bis 9, wobei der polymere piezoelektrische Körper ein Produkt von der Kristallinität und einer standardisierten molekularen Orientierung MORc, gemessen mit einem Molekülorientierungsmessgerät vom Mikrowellentransmissions-Typ, bezogen auf eine Referenzdicke von 50 μm, von 25 bis 700 aufweist.

**11.** Schichtkörper gemäß einem der Ansprüche 1 bis 10, wobei der aliphatische Polyester (A) ein Polymilchsäurepolymer mit einer Hauptkette ist, die eine durch die folgende Formel (1) dargestellte Wiederholungseinheit enthält

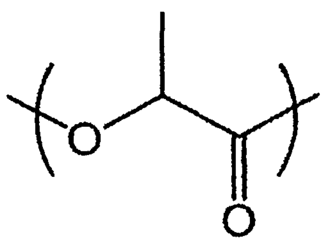

(1)

.

**12.** Schichtkörper gemäß einem der Ansprüche 1 bis 11, wobei der aliphatische Polyester (A) eine optische Reinheit von 95,00% ee oder mehr aufweist.

**13.** Schichtkörper gemäß einem der Ansprüche 1 bis 12, wobei ein Gehalt des aliphatischen Polyesters (A) im polymeren piezoelektrischen Körper 80 Massen-% oder mehr beträgt.

## Revendications

**1.** Corps stratifié comprenant :

un corps piézoélectrique polymère (11) qui contient un polyester aliphatique optiquement actif (A) ayant un poids moléculaire moyen en poids de 50 000 à 1000 000 et a une cristallinité obtenue par un procédé DSC, de 20 % à 80 % ; et

**caractérisé par** une couche (12) qui est en contact avec le corps piézoélectrique polymère et qui a un indice d'acide de 10 mg KOH/g ou moins.

**2.** Corps stratifié selon la revendication 1, dans lequel la couche (12) est une couche adhésive, une couche adhésive sensible à la pression, une couche de revêtement dure, une couche antistatique, une couche anti-adhérente, ou une couche d'ajustement de l'indice de réfraction.

**3.** Corps stratifié selon la revendication 1 ou 2, dans lequel la couche (12) est une couche adhésive sensible à la pression ou une couche adhésive.

**4.** Corps stratifié selon l'une quelconque des revendications 1 à 3, dans lequel l'indice d'acide de la couche (12) est de 0,01 mg KOH/g ou plus.

**5.** Corps stratifié selon l'une quelconque des revendications 1 à 4, dans lequel une quantité totale d'azote dans la couche (12) est de 0,05 % en masse à 10 % en masse.

**6.** Corps stratifié selon l'une quelconque des revendications 1 à 5, dans lequel le corps piézoélectrique polymère inclut de 0,01 partie en masse à 10 parties en masse d'un stabilisant (B), qui a au moins un groupe fonctionnel sélectionné à partir du groupe constitué par un groupe carbodiimide, un groupe époxy, et un groupe isocyanate, et qui a un poids moléculaire moyen en poids de 200 à 60 000, par rapport à 100 parties en masse du polyester aliphatique (A).

**7.** Corps stratifié selon la revendication 6, dans lequel le stabilisant (B) inclut un stabilisant (B1), qui a au moins un groupe fonctionnel sélectionné à partir du groupe constitué par un groupe carbodiimide, un groupe époxy, et un groupe isocyanate, et qui a un poids moléculaire moyen en poids de 200 à 900, et dans lequel le stabilisant (B) inclut un stabilisant (B2) qui a, dans une molécule, deux groupes fonctionnels ou plus d'un ou plusieurs types sélectionnés à partir du groupe constitué par un groupe carbodiimide, un groupe époxy, et un groupe isocyanate, et qui a un poids moléculaire moyen en poids de 1000 à 60 000.

**8.** Corps stratifié selon l'une quelconque des revendications 1 à 7, dans lequel le corps piézoélectrique polymère a un trouble interne par rapport à la lumière visible, de 50 % ou moins, et une constante piézoélectrique $d_{14}$ mesurée à 25 °C par un procédé de charge de contrainte, de 1 pC/N ou plus.

**9.** Corps stratifié selon l'une quelconque des revendications 1 à 8, dans lequel le corps piézoélectrique polymère a un trouble interne par rapport à la lumière visible, de 13 % ou moins, et inclut de 0,01 partie en masse à 2,8 parties en masse d'un stabilisant (B), qui a au moins un groupe fonctionnel sélectionné à partir du groupe constitué par un groupe carbodiimide, un groupe époxy, et un groupe isocyanate, et qui a un poids moléculaire moyen en poids de 200 à 60 000, par rapport à 100 parties en masse du polyester aliphatique (A).

**10.** Corps stratifié selon l'une quelconque des revendications 1 à 9, dans lequel le corps piézoélectrique polymère a un produit de la cristallinité et d'une orientation moléculaire normalisée MORc mesurée par un dispositif de mesure d'orientation moléculaire à transmission par micro-ondes sur la base d'une épaisseur de référence de 50 $\mu$m, de 25 à 700.

**11.** Corps stratifié selon l'une quelconque des revendications 1 à 10, dans lequel le polyester aliphatique (A) est un polymère d'acide polylactique ayant une chaîne principale contenant une unité répétée représentée par la formule (1) suivante

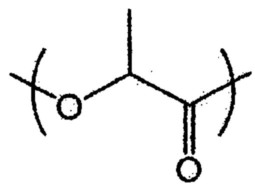

(1)

**12.** Corps stratifié selon l'une quelconque des revendications 1 à 11, dans lequel le polyester aliphatique (A) a une pureté optique de 95,00 % excès énantiomérique ou plus.

**13.** Corps stratifié selon l'une quelconque des revendications 1 à 12, dans lequel une teneur du polyester aliphatique (A) dans le corps piézoélectrique polymère est de 80 % en masse ou plus.

FIG.1

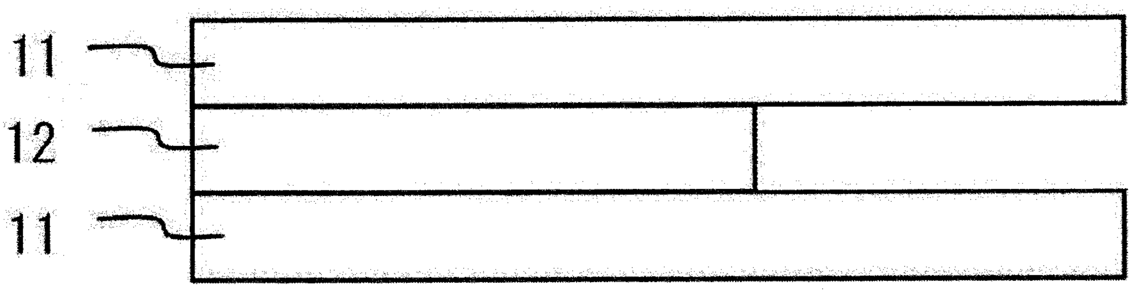

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H5152638 A
- JP 2005213376 A
- JP 2012056239 B
- WO 2010114056 A
- JP S59096123 A
- JP H7033861 A
- US 2668182 A
- US 4057357 A
- WO 2013054918 A
- US 2941956 A
- JP S4733279 B
- JP 4084953 B
- JP 2011256337 A
- JP 2013181698 A


### Non-patent literature cited in the description


- *J. Org. Chem.,* 1963, vol. 28, 2069-2075
- *Chemical Review,* 1981, vol. 81 (4), 619-621